# EUROPEAN PATENT APPLICATION

(11) **EP 2 602 825 A2**
(43) Date of publication of application: **12.06.2013**
(21) Application number: 12191733.0
(22) Date of filing: 08.11.2012
(51) Int. Cl.: H01L 29/12, H01L 29/06, H01L 33/04, H01L 33/14

(54) **Quantum Dot Device including Different Kinds of Quantum Dot layers**

(30) Priority: 09.12.2011 KR 20110132130
(71) Applicant: Samsung Electronics Co., Ltd, Gyeonggi-do 443-742 (KR)
(72) Inventor: Ku, Ji-yeon, 449-712 Gyeonggi-do (KR); Kim, Tae-ho, 449-712 Gyeonggi-do (KR); Chung, Dae-young, 449-712 Gyeonggi-do (KR); Cho, Kyung-sang, 449-712 Gyeonggi-do (KR); Choi, Byoung-lyong, 449-712 Gyeonggi-do (KR)
(74) Representative: Greene, Simon Kenneth

(57) **Abstract**

A quantum dot device includes: a cathode layer; an anode layer; an active layer that is disposed between the cathode layer and the anode layer and includes a quantum layer; and an electron movement control layer that is disposed between the cathode layer and the anode layer and includes a different kind of quantum layer having an energy level different from that of the quantum layer comprised in the active layer.

## Description

### BACKGROUND

### Field

Apparatuses and methods consistent with exemplary embodiments relate to quantum dot devices including different kinds of quantum dot layers.

### Description of the Related Art

Recently, interest in various electronic devices using a quantum dot is rising.

The quantum dot is a semiconductor material having a nanocrystal structure having a diameter of less than about 10 nanometers, and takes a quantum confinement effect. The quantum dot is formed more than hundreds of thousands of electrons. However, most of the electrons are strongly bound to an atomic nucleus, and thus, the number of free electrons that are not bounded to the atomic nucleus is limited in the range of about one to about a hundred. In this case, an electrons' energy level is discontinuously limited, and thus, the quantum dot shows electrical and optical characteristics different from those of a semiconductor in a bulk state forming a continuous energy band. Since the energy level of the quantum dot varies depending on the size thereof, it is possible to adjust the bandgap of the quantum dot by simply changing the size thereof. For example, in a case where the quantum dot is used in a light emitting device, an emission wavelength may be adjusted by only changing its size.

Thus, the quantum dot may be widely used in light emitting devices, solar cells, transistors, and display devices according to the above characteristics.

### SUMMARY

Aspects of one or more exemplary embodiments provide quantum dot devices in which the movement of electrons is controllable and which has high efficiency.

Additional aspects will be set forth in part in the description which follows and, in part, will be apparent from the description, or may be learned by practice of exemplary embodiments.

According to an aspect of an exemplary embodiment, a quantum dot device includes: a cathode layer; an anode layer; an active layer that is disposed between the cathode layer and the anode layer and comprises a quantum layer; and an electron movement control layer that is disposed between the cathode layer and the anode layer and comprises a different kind of quantum layer having an energy level different from that of the quantum layer comprised in the active layer.

The size of quantum dots of the electron movement control layer may be different from that of quantum dots of the active layer.

The electron movement control layer may include a material different from that of the active layer.

The electron movement control layer may be disposed between the active layer and the cathode layer.

The electron movement control layer may be disposed between the active layer and the anode layer or may be embedded in the active layer.

The electron movement control layer may include a single layer.

The electron movement control layer may include a plurality of layers.

The plurality of layers may be disposed adjacent to each other or may be disposed apart from each other with the active layer therebetween.

At least one of the plurality of layers may be embedded in the active layer.

The different kind of quantum layer included in the electron movement control layer may include: a first different kind of quantum dot layer having an energy level different from that of the active layer; and a second different kind of quantum dot layer having an energy level different from those of the active layer and the first different kind of quantum dot layer.

The size of quantum dots of the first different kind of quantum dot layer or the size of quantum dots of the second different kind of quantum dot layer may be different from that of quantum dots of the active layer.

The first different kind of quantum dot layer or the second different kind of quantum dot layer may include a material different from that of the active layer.

The first different kind of quantum dot layer and the second different kind of quantum dot layer may be disposed adjacent to each other.

The first different kind of quantum dot layer and the second different kind of quantum dot layer may be disposed apart from each other with the active layer therebetween.

The at least one of the first different kind of quantum dot layer and the second different kind of quantum dot layer may be embedded in the active layer.

An electron transport layer may be further disposed between the cathode layer and the active layer, and a hole transport layer may be further disposed between the anode layer and the active layer.

An electron injection layer may be further disposed between the cathode layer and the electron transport layer, and a hole injection layer may be further disposed between the anode layer and the hole transport layer.

### BRIEF DESCRIPTION OF THE DRAWINGS

These and/or other aspects will become apparent and more readily appreciated from the following description of exemplary embodiments, taken in conjunction with the accompanying drawings of which:
FIG. 1 is a schematic cross-sectional view showing a structure of a quantum dot device according to an exemplary embodiment;
FIG. 2 is a schematic cross-sectional view showing a structure of a quantum dot device according to another exemplary embodiment;
FIG. 3 is a schematic cross-sectional view showing a structure of a quantum dot device according to another exemplary embodiment;
FIG. 4A illustrates an example of a quantum dot layer structure used in a computer simulation;
FIG. 4B is a graph obtained by computer-simulating a current density variation while changing the size of quantum dots of some layer in the quantum dot layer of FIG. 4A; and
FIGS. 5 through 13 are schematic cross-sectional views showing structures of quantum dot devices according to various other exemplary embodiments.

### DETAILED DESCRIPTION OF EXEMPLARY EMBODIMENTS

Reference will now be made in detail to exemplary embodiments, examples of which are illustrated in the accompanying drawings. In the drawings, like reference numerals refer to like elements throughout and sizes of the respective elements may be exaggerated for clarity and convenience. In this regard, the present exemplary embodiments may have different forms and should not be construed as being limited to the descriptions set forth herein. Accordingly, exemplary embodiments are merely described below, by referring to the figures, to explain aspects of the present description.

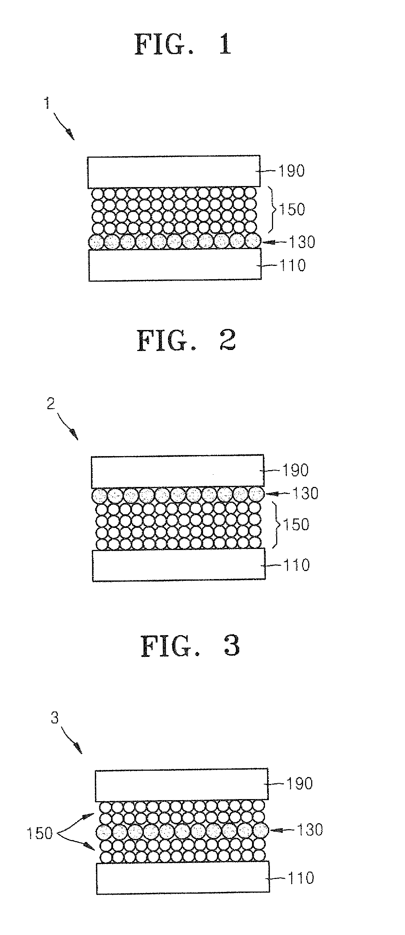

FIG. 1 is a schematic cross-sectional view showing a structure of a quantum dot device 1 according to an exemplary embodiment.

Referring to FIG. 1, the quantum dot device 1 is a light emitting device having a structure in which quantum dots are introduced in an active layer 150. As illustrated, the quantum dot device 1 includes the active layer 150 including a quantum dot layer, a cathode layer 190, and an anode layer 110. Voltages are applied to the cathode layer 190 and the anode layer 110 to inject electrons and holes into the active layer 150. In addition, the quantum dot device 1 further includes an electron movement control layer 130 disposed adjacent to the active layer 150. The electron movement control layer 130 is disposed to adjust and control an electron movement speed or electron distribution in the quantum dot device 1, and includes a different kind of quantum dot layer that has an energy level different from that of the quantum dot layer of the active layer 150.

A detailed configuration and material of the quantum dot device 1 according to one or more exemplary embodiments are described below.

The quantum dots of the active layer 150 may include at least one selected from the group consisting of a Si nanocrystal, a II-VI group compound semiconductor nanocrystal, a III-V group compound semiconductor nanocrystal, a IV-VI group compound semiconductor nanocrystal, and any combinations thereof. The II-VI group compound semiconductor nanocrystal may be any at least one selected from the group consisting of CdS, CdSe, CdTe, ZnS, ZnSe, ZnTe, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, CdZnSeS, CdZnSeTe, CdZnSTe, CdHgSeS, CdHgSeTe, CdHgSTe, HgZnSeS, HgZnSeTe, and HgZnSTe. The III-V group compound semiconductor nanocrystal may be any at least one selected from the group consisting of GaN, GaP, GaAs, AlN, AlP, AlAs, InN, InP, InAs, GaNP, GaNAs, GaPAs, AlNP, AlNAs, AlPAs, InNP, InNAs, InPAs, GaAlNP, GaAlNAs, GaAlPAs, GaInNP, GaInNAs, GaInPAs, InAlNP, InAlNAs, and InAlPAs. The IV-VI group compound semiconductor nanocrystal may be SbTe.

The quantum dots of the active layer 150 may be enveloped in a sealing element (not shown) in a state in which the quantum dots are dispersed naturally in a dispersion medium such as an organic solvent or a macromolecular resin. Any transparent medium that is not changed in quality by light or does not reflect light while not having an influence on an emission wavelength band of the quantum dots and does not cause a light absorption may be used as the dispersion medium.

For example, the organic solvent may include at least one selected from the group consisting of toluene, chloroform, and ethanol, and the macromolecular resin may include at least one selected from the group consisting of epoxy, silicone, polyethylene, and acrylate. When the macromolecular resin is used as the dispersion medium, a macromolecular resin in which quantum dots are dispersed may be injected into a sealing element and then be hardened.

A light emission of the active layer 150 including the quantum dot layer occurs when excited electrons transit from a conduction band to a valence band, and shows characteristics in which an emission wavelength varies depending on the size of the quantum dots even though the quantum dots are formed, for example, of the same material. Since a light having a shorter wavelength is emitted as the size of the quantum dots becomes smaller, it is possible to obtain a light in a desired wavelength range by adjusting the size of the quantum dots. The size of the quantum dots is adjustable by properly changing a growth condition of a nanocrystal thereof.

The electron movement control layer 130 includes a different kind of quantum dot layer to have an energy level different from that of the quantum dot layer of the active layer 150. An energy level difference between the electron movement control layer 130 and the active layer 150 may be determined to the extent in which an electron mobility characteristic of the quantum dot device 1 may be adjusted within the range in which the emission wavelength band of the active layer 150 is maintained. The electron movement control layer 130 may include quantum dots having a size different from that of the quantum dots of the active layer 150, may include quantum dots including a material different from that of the quantum dots of the active layer 150, or may include quantum dots having a size and a material different from those of the quantum dots of the active layer 150.

The cathode layer 190 and the anode layer 110 may include an electrode material, and, for example, may include indium tin oxide (ITO) or indium zinc oxide (IZO) as a transparent electrode material. In addition, at least one of the cathode layer 190 and the anode layer 110 may include a reflective metal material to radiate a light generated in the active layer 150 in a predetermined direction, for example, only in the up direction or down direction of the quantum dot device 1. For example, Al, Cu, or the like may be used as the reflective metal material.

Although a case in which the electron movement control layer 130 is disposed between the active layer 130 and the anode layer 110 is illustrated in FIG. 1, this case is only an example and one or more other exemplary embodiments are not limited thereto.

FIG. 2 is a schematic cross-sectional view showing a structure of a quantum dot device 2 according to another exemplary embodiment.

In the quantum dot device 2 of the present exemplary embodiment, an electron movement control layer 130 is disposed between a cathode layer 190 and an active layer 150 differently from the quantum dot device 1 of FIG. 1.

FIG. 3 is a schematic cross-sectional view showing a structure of a quantum dot device 3 according to another exemplary embodiment.

In the quantum dot device 3 of the present exemplary embodiment, an electron movement control layer 130 is embedded in an active layer 150 differently from the quantum dot device 1 of FIG. 1.

Related art devices using a quantum dot use a material such as a semiconductor polymer, an organic macromolecule, a ceramic, or the like to control and improve electron mobility and hole mobility, whereas the quantum dot devices according to exemplary embodiments described above use a quantum dot having an energy level different from that of the active layer 150. Since the size of the quantum dot and a material of the quantum dot may be easily adjusted, the electron mobility may be controlled in various ranges, and thus, the efficiency of the quantum dot device may be improved.

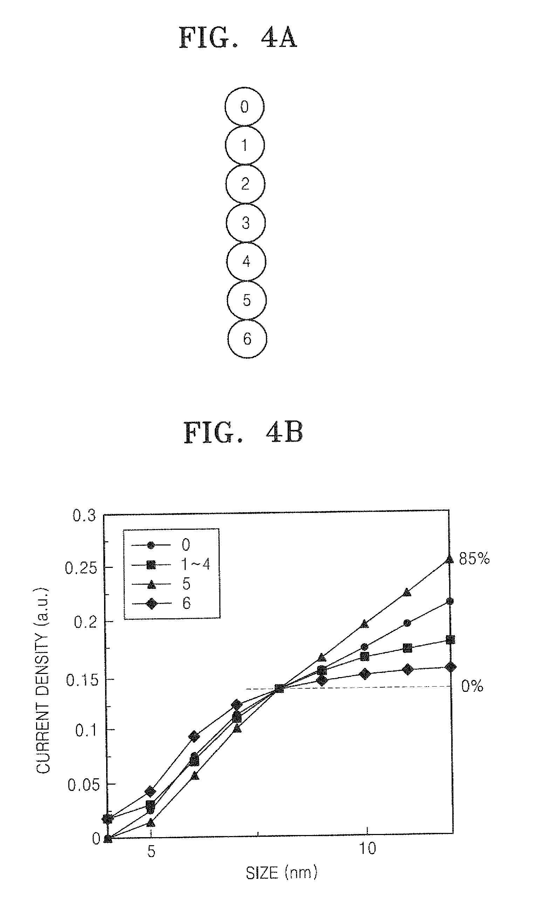

FIG. 4A illustrates an example of a quantum dot layer structure used in a computer simulation, and FIG. 4B is a graph obtained by computer-simulating a current density variation while changing the size of quantum dots of some layer in the quantum dot layer of FIG. 4A.

The quantum dot layer illustrated in FIG. 4A has seven layers, and it is assumed that, for convenience of the computer simulation, a single quantum dot exists in each of the seven layers. The graph of FIG. 4B is obtained by computer-simulating a current density variation while changing within a predetermined range the size of any one of quantum dots 0 through 6 illustrated in FIG. 4A. As illustrated, the computer simulation confirms that a current density may be increased to a maximum of 85% depending on a selection of a layer of which the size of a quantum dot will be varied and the change of the size of the quantum dot. From this, it is determined that an electron movement characteristic of the quantum dot device may be variously adjusted depending on changes of the location, the number of layers, and the size of the electron movement control layer 130 disposed adjacent to the active layer 150.

In addition, it has been experimentally confirmed that the electron mobility varies according to a configuration of quantum dots of the electron movement control layer 130 in a structure as the quantum dot device 1 of FIG. 1, that is, a structure in which the electron movement control layer 130 is disposed between the active layer 150 and the anode layer 110. In detail, when the active layer 150 includes green light emission quantum dots having a 110 nm thickness and the electron movement control layer 130 includes single layer quantum dots having a size equal to that of the quantum dots of the active layer 150 and of which material is the same as that of the quantum dots of the active layer 150, the electron mobility has been measured to have 1.53 × 10⁻⁴ cm²/Vs. On the other hand, when the electron movement control layer 130 includes single layer quantum dots that are red light emission quantum dots and have a size lager than that of the quantum dots of the active layer 150, the electron mobility has been measured to an about doubly increased value of 3.0 × 10⁻⁴ cm²/Vs. That is, it has been experimentally confirmed that the electron mobility may be increased depending on a configuration of the electron movement control layer 130.

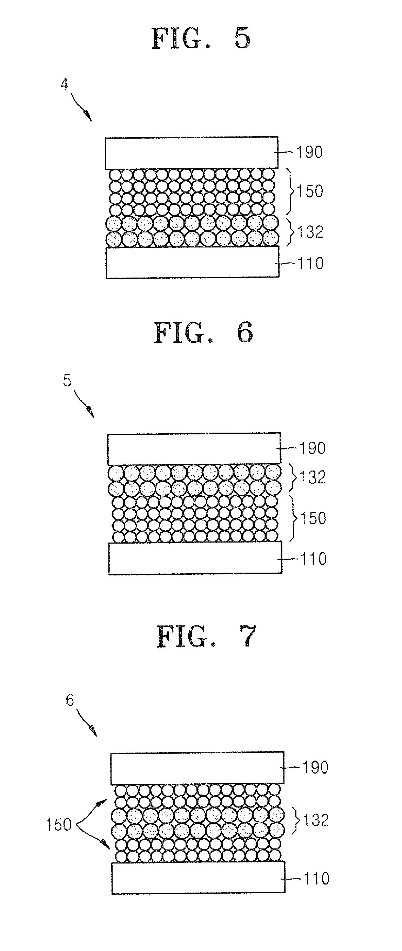

Below, with reference to FIGS. 5 through 13, configurations of quantum dot devices according to various other exemplary embodiments are described.

In a quantum dot device 4 of FIG. 5, an electron movement control layer 132 includes a quantum dot layer having two layers. The electron movement control layer 132 is disposed between an anode layer 110 and an active layer 150. Although a case in which the quantum dot layer of the electron movement control layer 132 includes quantum dots having a size larger than that of the quantum dots of the active layer 150 is illustrated in FIG. 5, this case is only an example, and the quantum dot layer of the electron movement control layer 132 may be formed of quantum dots having a size smaller than that of the quantum dots of the active layer 150. In addition, the quantum dot layer of the electron movement control layer 132 may include quantum dots including a material different from that of the quantum dots of the active layer 150 and having a size equal to that of the quantum dots of the active layer 150.

In the quantum dot device 5 of FIG. 6, an electron movement control layer 132 is disposed between an active layer 150 and a cathode layer 190 differently from the quantum dot device 5 of FIG. 5.

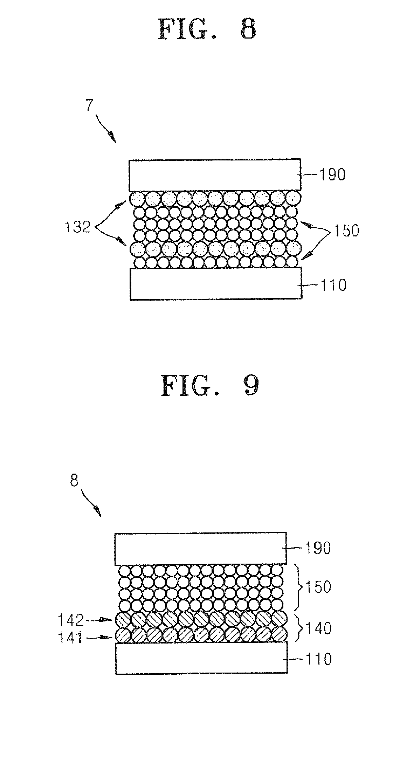

A quantum dot device 6 of FIG. 7 has a structure in which an electron movement control layer 132 is embedded in an active layer 150, and a quantum dot device 7 of FIG. 8 has a structure in which one of quantum dot layers forming the electron movement control layer 132 is embedded in an active layer 150.

In a quantum dot device 8 of FIG. 9, an electron movement control layer 140 includes a first different kind of quantum dot layer 141 having an energy level different from that of an active layer 150 and a second different kind of quantum dot layer 142 having an energy level different from that of the first different kind of quantum dot layer 141.

The size of quantum dots of the first different kind of quantum dot layer 141 is different from that of quantum dots of the active layer 150. Although a case in which the size of quantum dots of the first different kind of quantum dot layer 141 is larger than that of quantum dots of the active layer 150 is illustrated in FIG. 9, the size of the quantum dots of the first different kind of quantum dot layer 141 may be smaller than that of the quantum dots of the active layer 150. In addition, quantum dots of the second different kind of quantum dot layer 142 may be of a material different from that of the quantum dots of the first different kind of quantum dot layer 141, and, as illustrated in FIG. 9, the quantum dots of the second different kind of quantum dot layer 142 may have a size equal to that of the quantum dots of the first different kind of quantum dot layer 141. However, this is only an example, and the quantum dots of the second different kind of quantum dot layer 142 may be of a material that is the same as that of the quantum dots of the first different kind of quantum dot layer 141, and may have a size different from that of the quantum dots of the first different kind of quantum dot layer 141. In addition, the quantum dots of the second different kind of quantum dot layer 142 may be of a material different from that of the quantum dots of the first different kind of quantum dot layer 141, and may have a size different from that of the quantum dots of the first different kind of quantum dot layer 141.

As illustrated in FIG. 9, the first different kind of quantum dot layer 141 and the second different kind of quantum dot layer 142 may be disposed adjacent to each other, and may be disposed on the anode layer 110.

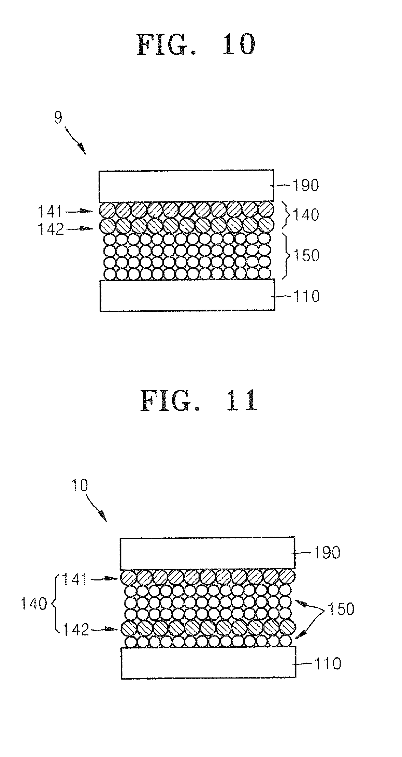

In the quantum dot device 9 of FIG. 10, an electron movement control layer 140 is disposed between an active layer 150 and a cathode layer 190 differently from the quantum dot device 8 of FIG. 9.

In a quantum dot device 10 of FIG. 11, any one layer of quantum dot layers of an electron movement control layer 140 is embedded in an active layer 150 differently from the quantum dot device 9 of FIG. 10. A second different kind of quantum dot layer 142 is embedded in the active layer 150, and the first different kind of quantum dot layer 141 is disposed between a cathode layer 190 and the active layer 150. The first different kind of quantum dot layer 141 may be disposed between an anode layer 110 and the active layer 150.

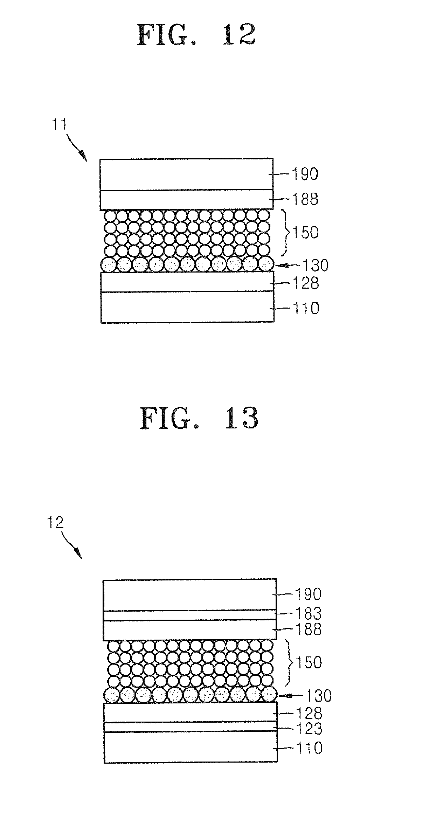

In a quantum dot device 11 of FIG. 12, differently from the quantum dot device 1 of FIG. 1, an electron transport layer 188 is included between a cathode layer 190 and an active layer 150, and a hole transport layer 128 is included between an anode layer 110 and the active layer 150.

The electron transport layer 188 may include at least one of various material capable of transmitting electrons to the active layer 150. For example, the electron transport layer 188 may include a metal oxide such as TiO₂, ZrO₂, or HfO₂ , or an inorganic substance including Si₃N₄. In addition, the electron transport layer 188 may include an N-type semiconductor material, for example, n-AlₓGayIn_{z}N (x+y+z=1) or the like. Although a case in which the electron transport layer 188 is a single layer is illustrated in FIG. 12, this case is only an example, and the electron transport layer 188 may include multiple layers.

The hole transport layer 128 may include at least one of various material capable of transmitting holes to the active layer 150. For example, the hole transport layer 128 may include a conductive macromolecule material such as PEDOT, PSS, PPV, PVK, or the like. In addition, the hole transport layer 128 may include a P-type semiconductor material, for example, p-AlₓGa_{y}In_{z}N (x+y+z=1) or the like. Although a case in which the hole transport layer 128 is a single layer is illustrated in FIG. 12, this case is only an example, and the hole transport layer 128 may include multiple layers.

Although a case in which the electron transport layer 188 and the hole transport layer 128 are added to the quantum dot device 1 of FIG. 1 is illustrated in FIG. 12, the electron transport layer 188 and the hole transport layer 128 may be added to the quantum dot devices 2 through 10 of FIGS. 2, 3, and 5 through 11.

In a quantum dot device 12 of FIG. 13, differently from the quantum dot device 11 of FIG. 12, an electron injection layer 183 is further included between a cathode layer 190 and an electron transport layer 188, and a hole injection layer 123 is further included between the anode layer 190 and the hole transport layer 128. Although a case in which the quantum dot device 12 adopts the structure of the electron movement control layer 130 of the quantum dot device of FIG. 1 is illustrated in FIG. 13, the quantum dot device 12 may adopt the structures of the electron movement control layers 130, 132, and 140 of the quantum dot devices 2 through 10 of FIGS. 2, 3, and 5 through 11.

In the quantum dot devices described above, by introducing a different kind of quantum dot layer having an energy level different from that of a quantum dot layer of an active layer, electrical characteristics such as electron mobility may be adjusted, and a high efficiency may be obtained.

In addition, by adjusting at least one of a material, a size, and a disposition of quantum dots of the different quantum dot layer, an electron movement speed or dispersion of electrons in the quantum dot devices may be controlled.

The above-described exemplary embodiments exemplify a case in which an electron movement control layer including quantum dots having an energy level different from that of quantum dots of an active layer is adopted in a quantum dot device applied as a light emitting device. However, the electron movement control layer according to exemplary embodiments may be widely adopted in other devices, such as solar cells, transistors, and display devices, which use quantum dots.

While exemplary embodiments have been particularly shown and described above, it will be understood by those of ordinary skill in the art that various changes in form and details may be made therein without departing from the scope of the present inventive concept as defined by the following claims.

## Claims

1. A quantum dot device comprising:
a cathode layer;
an anode layer;
an active layer that is disposed between the cathode layer and the anode layer and comprises a first quantum layer; and
an electron movement control layer that is disposed between the cathode layer and the anode layer and comprises a second quantum layer having a different size to the quantum dots of the first quantum layer and/or a different material to the first quantum layer so that the second quantum layer has an energy level different from an energy level of the first quantum layer comprised in the active layer.

2. The quantum dot device of claim 1, wherein a size of quantum dots the second quantum layer is different from a size of quantum dots of the first quantum layer.

3. The quantum dot device of claim 1 or 2, wherein a material of quantum dots of the second quantum layer is different from a material of quantum dots of the first quantum layer.

4. The quantum dot device of any preceding claim, wherein the electron movement control layer is disposed between the active layer and the cathode layer.

5. The quantum dot device of any of claims 1 to 3, wherein the electron movement control layer is disposed between the active layer and the anode layer.

6. The quantum dot device of any of claims 1 to 3, wherein the electron movement control layer is embedded in the active layer.

7. The quantum dot device of any of claims 1 to 6, wherein the electron movement control layer comprises a plurality of layers,
and preferably wherein the plurality of layers are disposed directly adjacent to each other, or wherein the plurality of layers are disposed apart from each other with at least a portion of the active layer therebetween, or wherein at least one of the plurality of layers is embedded in the active layer.

8. The quantum dot device of any preceding claim, wherein the second quantum layer comprised in the electron movement control layer comprises:
a first different kind of quantum dot layer having an energy level different from the energy level of the first quantum layer;
a second different kind of quantum dot layer having an energy level different from the energy level of the first quantum layer and the energy level of the first different kind of quantum dot layer,
and preferably wherein at least one of a size of quantum dots of the first different kind of quantum dot layer and a size of quantum dots of the second different kind of quantum dot layer is different from a size of quantum dots of the first quantum layer.

9. The quantum dot device of claim 8, wherein at least one of a material of the first different kind of quantum dot layer and a material of the second different kind of quantum dot layer is different from a material of the first quantum layer.

10. The quantum dot device of claim 8, wherein the first different kind of quantum dot layer and the second different kind of quantum dot layer are disposed directly adjacent to each other.

11. The quantum dot device of claim 8 or 9, wherein the first different kind of quantum dot layer and the second different kind of quantum dot layer are disposed apart from each with at least a portion of the active layer therebetween.

12. The quantum dot device of claim 8, 9, 10 or 11, wherein at least one of the first different kind of quantum dot layer and the second different kind of quantum dot layer is embedded in the active layer.

13. The quantum dot device of any preceding claim, further comprising an electron transport layer disposed between the cathode layer and the active layer, and a hole transport layer disposed between the anode layer and the active layer,
and preferably further comprising an electron injection layer disposed between the cathode layer and the electron transport layer, and a hole injection layer disposed between the anode layer and the hole transport layer.

14. The quantum dot device of any preceding claim, wherein at least one of the cathode layer and the anode layer comprises a reflective material to radiate a light generated in the active layer in a predetermined direction.

15. The quantum dot device of any preceding claim, wherein the first quantum layer is enveloped in a sealing element and quantum dots of the first quantum layer are dispersed in an organic solvent or a macromolecular resin.
